# EUROPÄISCHE PATENTANMELDUNG

(11) **EP 1 318 410 A1**
(43) Veröffentlichungstag der Anmeldung: **11.06.2003**
(21) Anmeldenummer: 01890332.8
(22) Anmeldetag: 06.12.2001
(51) Int. Cl.: G01R 31/02

(54) **Prüfvorrichtung und Prüfverfahren für Flachleiter**

(71) Anmelder: I & T Flachleiter Produktions-Ges.m.b.h., 7000 Eisenstadt (AT)
(72) Erfinder: Schindler, Uwe, 22941 Bargteheide (DE)
(74) Vertreter: Patentanwälte BARGER, PISO & PARTNER

(57) **Zusammenfassung**

Die Erfindung betrifft eine Prüfvorrichtung für Flachleiter, die als Endlosware oder Meterware vorliegen.

Die Erfindung ist dadurch gekennzeichnet, dass die Kontaktvorrichtung (1) des eigentlichen Prüfgerätes mit einer Aufnahme (9) versehen ist, die das Einschieben des Endes des zu prüfenden Flachleiters (7) erlaubt, und dass in dieser Aufnahme elektrisch leitfähige Kontaktstifte (5,6) so beweglich vorgesehen sind, dass sie aus einer ersten, nicht in den Bereich des Flachleiters (7) ragenden Lage in eine zweite, in den Bereich des Flachleiters ragenden Lage bewegbar sind und dass sie in der zweiten Lage zumindest durch die ihnen zugewandte Isolationsschichte des zu prüfenden Flachleiters (7) und durch zumindest einen Teil der Dicke der im Flachleiter befindlichen Leiterbahnen ragen.

Die Erfindung betrifft auch ein Verfahren zum Prüfen von Flachicitern.

## Beschreibung

Die Erfindung betrifft eine Prüfvorrichtung und ein Prüfverfahren für Flachleiter, die als Endlosware oder Meterware vorliegen.

Es werden in den verschiedensten Gebieten der automatischen Fertigung, insbesondere aber in jüngster Zeit in der Automobilindustrie, Flachleiter eingesetzt. Bei diesen Flachleitern sind Leiterbahnen aus Kupfer im Abstand voneinander und im wesentlichen innerhalb einer Ebene parallel zueinander angeordnet und voneinander und nach außen entweder durch Kunststofflaminat oder durch eine im Zuge eines Extrusionsprozesses aufgebrachte Kunststoffumhüllung isoliert. Der Querschnitt der eigentlichen Leiter aus Kupfer kann dabei unterschiedlich sein, doch werden aus verschiedenen Gründen auch in der Automobilindustrie, in der verhältnismäßig große Leistungen übertragen werden müssen, Kupferfolien zur Herstellung der Leiter verwendet, die zum Teil eine Dicke (Erstreckung normal zur Ebene des Flachleiters) aufweisen, die im Bereich von einem oder einigen wenigen Zehntelmillimetern liegt.

Diese Flachleiter werden, von ihrem Herstellungsort kommend, zumeist auf Rollen aufgewickelt und müssen, bevor sie ausgeliefert werden können, zumindest auf elektrischen Durchgang, bevorzugt auch auf elektrischen Widerstand und Isolationswiderstand geprüft werden. Dazu wird der "Anfang" des aufgewickelten Flachleiters auf der Rolle zu Beginn des Wickelns durch eine Öffnung geführt, sodass er zugänglich ist, und das "Ende" ist nach dem Wickeln im Mantelbereich der Rolle ohne weiteres zugänglich.

Trotz der eingangs erwähnten zunehmenden Verwendung derartiger Flachleiter in verschiedenen Bereichen der Industrie sind sowohl die laminierten als auch die extrudierten Flachleiter noch relativ exotische Gebilde und dies ist wohl der Grund dafür, dass die genannte Endkontrolle auf eine Weise erfolgt, wie sie von Rundkabeln her bekannt ist: Die Flachleiter werden händisch abisoliert, mittels Krokodilklemmen od.dergl. werden die eigentlichen Leiter mit dem Prüfgerät verbunden und sodann wird Leiter für Leiter die Prüfung durchgeführt.

Da nun, wie oben ausgeführt, die Querschnitte und insbesondere die Dicken der Kupferleiter immer geringer werden, kommt es bei diesem Arbeitsvorgang zunehmend zu Problemen, einerseits beim Abisolieren, wo es leicht möglich ist, auch den Leiter zu durchtrennen und nicht nur die ihn abdeckende Schichte, andererseits auch beim Kontaktieren, wenn beispielsweise die Krokodilklemme den Leiter so erfaßt, dass sie ihn abtrennt, so dass der gesamte Prüfvorgang wiederholt werden muß. Besonders unangenehm ist es, wenn die Krokodilklemme keinen richtigen Kontakt herstellt, aber mit einer der beiden Isolierschichten mechanisch verbunden ist, so dass irrtümlich ein Fehler des Flachleiters festgestellt wird, obwohl nur der Kontakt zwischen der Klemme und dem Leiter ungenügend war.

Die Erfindung hat das Ziel, eine Vorrichtung und ein Verfahren zur Prüfung eines Flachleiters zu schaffen, bei dem die genannten Probleme nicht auftreten und mit dem es möglich ist, auf einfache und kostensparende Weise Flachleiter auf ihre Funktionsfähigkeit zu prüfen.

Erfindungsgemäß geschieht dies dadurch, dass die Kontaktvorrichtung des eigentlichen Prüfgerätes mit einer Aufnahme versehen ist, die das Einschieben des Endes des zu prüfenden Flachleiters erlaubt, und dass in dieser Aufnahme elektrisch leitfähige Kontaktstifte so beweglich vorgesehen sind, dass sie aus einer ersten, nicht in die Aufnahme ragenden Lage in eine zweite, in die Aufnahme ragende Lage bewegbar sind und dass sie in der zweiten, in die Aufnahme ragenden Lage zumindest durch die ihnen zugewandte Isolationsschichte des zu prüfenden Flachleiters und durch zumindest einen Teil der Dicke der im Flachleiter befindlichen Leiterbahnen gelangen.

Es wird auf diese Weise ermöglicht, einen Flachleiter zu Prüfzwecken zu kontaktieren, ohne ihn vorher abisolieren zu müssen. Beim Vorwärtsbewegen der Prüfstifte dringen diese durch das Isolationsmaterial, das sie aufschneiden und/oder weg drücken und sie dringen in der Folge in die eigentlichen Kupferleiter ein oder durch diese durch, wodurch sie die Kontaktierung mit diesen zuverlässig erreichen.

Es ist dabei möglich, dass die Stifte sich in Führungen des Prüfgerätes bewegen, doch ist es auch möglich, dass die Stifte in einem Teil der Aufnahme sitzen, der sich gegenüber dem anderen Teil der Aufnahme so bewegt, dass die Stifte sich auf den eingeschobenen Flachleiter zu bewegen.

Es ist selbstverständlich notwendig, dass die Stifte in der Richtung quer zur Flachleiterlängsachse einen Abstand voneinander aufweisen, der mit den Abständen der Kupferleiter des zu untersuchenden Flachleiters übereinstimmt, doch stellt dies in Anbetracht der Ausbildung fester Raster bei den Flachleitern, die derzeit verwendet werden, keine Probleme darstellt.

Bei unterschiedlichen Rastern oder bei sehr engen Rastern sind die Kontakte bevorzugt nicht in einer Reihe, sondern in einer zick-zack-Positionierung angeordnet, um Platz für die Mechanik der Kontaktbewegung und für die Kontaktierung der Kontaktstifte zu sorgen und um einen ausreichenden Abstand zwischen den Kontakten, beispielsweise bei der Verwendung von Hochspannung im Zuge der Prüfung, zu schaffen.

Selbstverständlich ist es auch möglich, dass die Kontaktstifte den Flachleiter zur Gänze durchstoßen und gegebenenfalls in Vertiefungen, Ausnehmungen oder einen elastischen Bauteil der Aufnahme, in der sie angeordnet sind, eindringen, es wird in diesem Fall bevorzugt, die Kontaktstifte konisch auszubilden, um zu einer zuverlässigen Kontaktierung zu kommen. Auch die Ausbildung einer Stufe oder einer Änderung des Konuswinkels der Stifte in dem Bereich, in dem sie die eigentlichen Leiterbahnen kontaktieren, ist möglich, durch eine solche Ausbildung wird der Kontakt der einzelnen Stifte mit den Leiterbahnen verbessert.

Trotz der hohen Genauigkeit, mit der die Flachleiter hergestellt werden, kann nicht sichergestellt werden, dass sich die einzelnen Leiterbahnen tatsächlich immer innerhalb einer Ebene befinden und dass sie, wenn die Leiterbahnen selbst rechteckigen Querschnitt aufweisen, völlig parallel zueinander und genau parallel zur Ebene des Flachleiters verlaufende Ober- bzw. Unterflächen aufweisen. Dies gilt insbesondere für Flachleiter, die im Zuge eines Extrusionsprozesses hergestellt worden sind, da es dabei nicht möglich ist, während des endgültigen Erkaltens des Extrudates die Leiter selbst noch zu führen und in ihrer Lage zu fixieren.

Speziell für derartige Flachleiter wird es bevorzugt, dass die Prüfstifte den gesamten Flachleiter durchdringen, durch ihre konische Ausbildung die Isolierschichte beiseite schieben und den Kupferleiter deformieren, wobei es durch diese Deformation zu einer zuverlässigen elektrischen Kontaktierung kommt. Es können, speziell für diese Fälle, auch mehrere Kontaktstifte pro Leiterbahn vorgesehen werden, die dann, quer zur Leiterlängsachse, bevorzugt leicht versetzt zueinander angeordnet sind, um sicherzustellen, dass zumindest einer der Kontaktstifte den Kupferleiter tatsächlich ausreichend kontaktiert.

Die Erfindung betrifft auch ein Verfahren zum Prüfen von Flachleitern, das darin besteht, das Isolationsmaterial des Flachleiters mittels spitzer Kontaktstifte zumindest einseitig zu perforieren und so die Kontaktstifte mit den eigentlichen Leitern in elektrisch leitenden Kontakt zu bringen.

Die Erfindung wird im folgenden anhand zweier Ausführungsbeispiele näher erläutert. Dabei zeigt
die Fig. 1 eine erste im wesentlichen symmetrische Ausführungsform und
die Fig. 2 eine asymmetrische Variante.

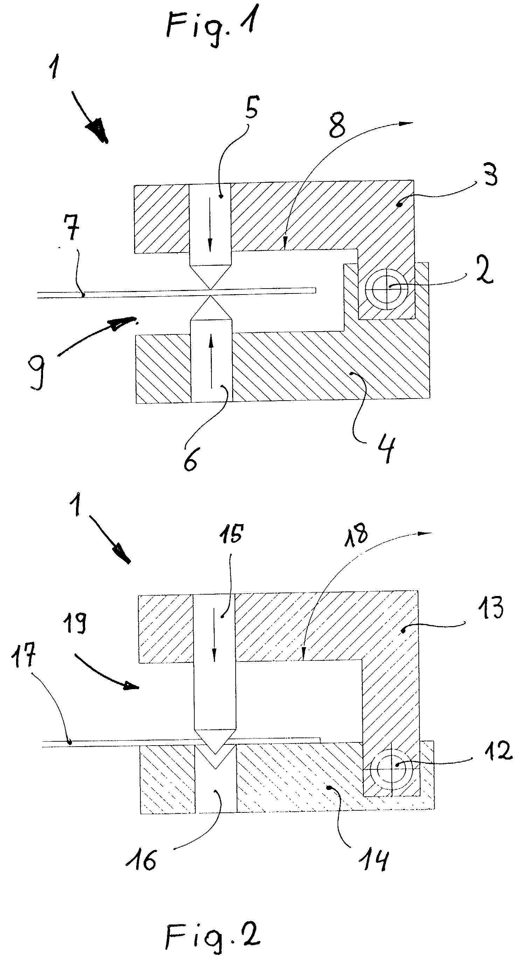

In Fig. 1 ist rein schematisch und ohne auf die Fragen der Ergonomie, der Kontaktierung der Kontaktstifte, der Verbindung der erfindungsgemäßen Prüfvorrichtung mit dem eigentlichen Prüfgerät etc. einzugehen, eine Kontaktvorrichtung 1 eines erfindungsgemäßen Prüfgerätes dargestellt. Diese Kontaktvorrichtung besteht im wesentlichen aus zwei Schenkeln 3, 4, die zueinander um eine Achse 2 verschwenkbar sind und zwischen sich eine Aufnahme 9 ausbilden, die das Einschieben eines Endes eines Flachleiters 7 erlaubt. In der Ausführungsform gemäß Fig. 1 is jeder der Schenkel 3, 4 mit Kontaktstiften 5, 6 versehen, die in die Aufnahme 9 ragen. Im gezeigten Ausführungsbeispiel sind die Kontaktstifte 5 des Schenkels 3 zueinander fluchtend angeordnet, so dass nur der vorderste der Kontaktstifte sichtbar ist. Das gleiche gilt für die Kontaktstifte 6 des Schenkels 4.

Wenn nun bei eingeschobenem Flachleiter 7 die beiden Schenkel 3, 4 um die Achse 2 zueinander bewegt werden, angedeutet durch den Doppelpfeil 8, so dringen die Spitzen der Kontaktstifte 5, 6 durch das Isolationsmaterial des Flachleiters 7 und stoßen im Bereich der eigentlichen Leiterbahnen aneinander, wodurch eine sichere Kontaktierung und gleichzeitig eine sichere mechanische Verbindung erreicht wird.

In der Praxis kann diese Position durch eine Feder, eine Rast od.dgl. fixiert werden, um zu verhindern, dass während des eigentlichen Meßvorganges die Kontaktierung zwischen den Kontaktstiften 5, 6 und den Leiterbahnen des Flachleiters 7 geändert wird.

Die Fig. 2 zeigt eine Variante, vergleichbare Bauteile sind mit den gleichen Bezugszeichen versehen, denen nur jeweils die Ziffer "1" vorangestellt worden ist. Im Unterschied zur Kontaktvorrichtung 1 ist die Kontaktvorrichtung 11 asymmetrisch aufgebaut und weist nur in ihrem Schenkel 13 Kontaktstifte 15 auf, statt der Kontaktstifte 6 ist eine Aufnahme 16 vorgesehen, die die Bewegung der Kontaktstifte 15 begrenzt und für eine sichere mechanische Verbindung zwischen dem Flachleiter und der Kontaktvorrichtung 11 sorgt. Dabei muß die Stiftaufnahme 16 nicht aus elektrisch leitendem Material bestehen, wenn dies auch wegen der Zuverlässigkeit der Kontaktierung bevorzugt wird.

Aus der Zeichnung ist ersichtlich, dass es auch viele Varianten und andere Ausführungsformen geben kann: So ist es, wie bereits kurz erwähnt möglich, die beiden Schenkel 3, 4 bzw. 13, 14 stark miteinander zu verbinden und dafür die Kontaktstifte 5 und/oder 6 bzw. 15 beweglich, nämlich längsverschieblich im jeweiligen Schenkel vorzusehen und durch eine entsprechende Bewegung der Kontaktstifte die Kontaktierung mit den Leiterbahnen der Flachleiter 7, 17 zu erreichen. Da dabei die mechanischen Ausbildungen der Kontaktvorrichtung aufwendiger sind als im gezeigten Beispiel, ist dies nur für besondere Fälle, beispielsweise zur Kontaktierung von Flachleitern, bei denen die einzelnen Leiterbahnen mit individuellem Anpreßdruck od.dgl. kontaktiert werden sollen, empfehlenswert.

Die verwendeten Materialien sind auf dem Gebiete des Baues von Prüf- und Meßgeräten üblich und bekannt und können vom Fachmann in Kenntnis der Erfindung leicht gewählt werden. So bietet sich als Material für die Schenkel 3, 4, 13, 14 spritzgußfähiger Kunststoff an, in den bei der Ausführungsform, wie sie in der Zeichnung dargestellt ist, die Kontaktstifte 5, 6, 15 und die Kontaktstiftaufnahme 16 nach Art verlorener Kerne eingespritzt sind. Selbstverständlich ist es möglich, die Schenkel aus Profilen herzustellen, die durch spanende Bearbeitung die Kontaktstifte aufnehmen können, diese können dann in den entsprechenden Öffnungen eingeklebt oder durch Reibschluß festgehalten werden.

## Patentansprüche

1. Prüfvorrichtung für Flachleiter, die als Endlosware oder Meterware vorliegen, **dadurch gekennzeichnet, dass** die Kontaktvorrichtung (1,11) des eigentlichen Prüfgerätes mit einer Aufnahme (9,19) versehen ist, die das Einschieben des Endes des zu prüfenden Flachleiters (7,17) erlaubt, und dass in dieser Aufnahme elektrisch leitfähige Kontaktstifte (5,6; 15) so beweglich vorgesehen sind, dass sie aus einer ersten, nicht in den Bereich des Flachleiters (7,17) ragenden Lage in eine zweite, in den Bereich des Flachleiters ragenden Lage bewegbar sind und dass sie in der zweiten Lage zumindest durch die ihnen zugewandte Isolationsschichte des zu prüfenden Flachleiters (7,17) und durch zumindest einen Teil der Dicke der im Flachleiter befindlichen Leiterbahnen ragen.

2. Prüfvorrichtung nach Anspruch 1, **dadurch gekennzeichnet, dass** die Kontaktstifte (5,6; 15) fest in zueinander beweglichen Schenkeln (3,4; 13,14) der Kontaktvorrichtung angeordnet sind.

3. Prüfvorrichtung nach Anspruch 2, **dadurch gekennzeichnet, dass** die Schenkeln (3,4; 13,14) der Kontaktvorrichtung (1,11) um eine Achse (2,12) zueinander verschwenkbar sind.

4. Prüfvorrichtung nach Anspruch 1, **dadurch gekennzeichnet, dass** die Kontaktstifte beweglich in relativ zueinander unbeweglichen Schenkeln gelagert sind.

5. Prüfvorrichtung nach einem der voranstehenden Ansprüche, **dadurch gekennzeichnet, dass** die Kontaktstifte zueinander in Richtung der Längsachse des in die Aufnahme (9,19) eingeschobenen Flachleiters (7,17) versetzt angeordnet sind.

6. Prüfvorrichtung nach einem der voranstehenden Ansprüche, **dadurch gekennzeichnet, dass** die Kontaktvorrichtung in der kontaktierenden Position fixierbar ist.

7. Prüfvorrichtung nach einem der voranstehenden Ansprüche, **dadurch gekennzeichnet, dass** die Kontaktvorrichtung von einer Feder in ihre offene, nicht kontaktierende Position gedrängt wird.

8. Verfahren zum Prüfen von Flachleitern, **dadurch gekennzeichnet, dass** das Isolationsmaterial des Flachleiters mittels spitzer Kontaktstifte zumindest einseitig perforiert und so die Kontaktstifte mit den eigentlichen Leitern kontaktiert werden.
